# EUROPEAN PATENT APPLICATION

(11) **EP 2 387 067 A1**
(43) Date of publication of application: **16.11.2011**
(21) Application number: 10729251.8
(22) Date of filing: 08.01.2010
(51) Int. Cl.: H01L 21/60, C08G 59/62, C09K 3/10, H01L 21/56, H01L 23/29, H01L 23/31, H01L 25/065, H01L 25/07, H01L 25/18

(54) **METHOD FOR MANUFACTURING SEMICONDUCTOR PACKAGE, METHOD FOR ENCAPSULATING SEMICONDUCTOR, AND SOLVENT-BORNE SEMICONDUCTOR ENCAPSULATING EPOXY RESIN COMPOSITION**

(30) Priority: 09.01.2009 JP 2009003451
(71) Applicant: Nagase ChemteX Corporation, Osaka-shi, Osaka 550-8668 (JP)
(72) Inventor: NOMURA, Kazuhiro, Tatsuno-shi Hyogo 679-4124 (JP); ISOBE, Tomoki, Tatsuno-shi Hyogo 679-4124 (JP)
(74) Representative: Vossius & Partner
(86) International application number: PCT/JP2010/050171
(87) International publication number: WO 2010/079831

(57) **Abstract**

Disclosed is a novel method for manufacturing a semiconductor package, which can suppress the formation of voids in an encapsulating resin. Specifically disclosed is a method for manufacturing a semiconductor package, which comprises: (1) a step wherein a first member, which is selected from a group consisting of semiconductor chips and circuit boards, is coated with solvent borne semiconductor encapsulating epoxy resin composition that essentially contains (A) an epoxy resin, (B) a phenol novolac resin in such an amount that the mole number of phenolic hydroxyl groups is 0.8-1.2 times the mole number of epoxy groups in the component (A), (C) a curing accelerator and (D) a solvent: (2) a step wherein the coated composition is dried by volatilizing the solvent therefrom; and (3) a step wherein the first member and a second member, which is selected from a group consisting of semiconductor chips and circuit boards to form, together with the first member, a semiconductor chip/circuit board pair or a semiconductor chip/semiconductor chip pair, are thermally compression bonded with each other with the coated and dried composition interposed therebetween.

## Description

### TECHNICAL FIELD

The present invention relates to a method for manufacturing a semiconductor package, a method for encapsulating a semiconductor, and a solvent borne semiconductor-encapsulating epoxy resin composition to be used for these methods, and more particularly to a method of mounting a semiconductor chip and a solvent borne semiconductor-encapsulating epoxy resin composition to be used for the method.

### BACKGROUND ART

As a method for mounting a semiconductor chip, a flip chip mounting has been increasing in response to a request of for reduction in the size and weight of a package. In performing flip chip mounting, a method called, for example, a pressure welding method, in which a sealing or encapsulating resin is supplied in advance onto a substrate, then a bump of metal, such as a gold, provided on a semiconductor chip is thermally compression bonded to a portion provided on a circuit board, that is the portion being called pad and having been provided with gold plating or a tin-solder plating, so that electrical connection by the bump and the pad and curing of the sealing resin are performed simultaneously. Furthermore, in recent years have been researched high-density mounting methods, such as a chip-on-chip (COC) method in which one semiconductor chip having been mounted by wire connection is laminate connected to another chip and a Through Silicon Via (TSV) method in which a through hole is formed in a semiconductor chip to form an electrode that connects the front surface of the chip with the rear surface of the chip and then two or more semiconductor chips are laminate connected by using that electrode. Also in these technologies, simultaneous execution of the curing of an encapsulating resin and electrical connection has been expected.

In such a case, two methods mainly have heretofore been adopted. The two methods are a method using a resin sheet for encapsulating a semiconductor in which a thermoplastic resin has been incorporated as a sheeting agent in a thermosetting resin and a method using a solventless type liquid epoxy resin for encapsulating a semiconductor.

Various kinds of solventless type liquid epoxy resin compositions for encapsulating semiconductors are known, and, for example, a liquid epoxy resin composition in which methylhexahydrophthalic anhydride and allylated phenol novolac resin are used as curing agents has been disclosed in Patent Document 1 as a liquid epoxy resin composition for spot sealing semiconductor chips. Moreover, an epoxy resin composition for encapsulating LSI in which an acid anhydride, such as tetrahydrophthalic anhydride, is used has been disclosed in Patent Document 2, and a liquid epoxy resin composition for chip-on-film containing methylhexahydrophthalic anhydride and a phenolic compound curing agent has been disclosed in Patent Document 3. An adhesive resin sheet containing an epoxy resin, a phenol resin, and a large amount of thermoplastic resin has been disclosed as a resin sheet for encapsulating semiconductors in Patent Document 4.

However, the method of using a solventless type liquid epoxy resin composition for encapsulating a semiconductor has had a problem that voids are formed in a liquid resin in which a curing reaction has not fully progressed when joining a chip at a high temperature. Furthermore, there has also been a problem that voids are engulfed by the flow of the liquid resin. Moreover, the method of using a resin sheet has had a problem that the performance of an epoxy resin is impaired due to the incorporation of a thermoplastic resin, resulting in deterioration of the performance of a sealant. Furthermore, the method of using a resin sheet has had a problem that the resin sheet cannot deform in conformity with the suface unevenness formed by densely provided wires, so that voids tend to be formed at the bases of protrusions.

### PRIOR ART DOCUMENTS

### PATENT DOCUMENTS

Patent Document 1: Japanese Patent Application Laid-Open No. 6-306143
Patent Document 2: Japanese Patent Application Laid-Open No. 2000-198831
Patent Document 3: Japanese Patent Application Laid-Open No. 2008-7577
Patent Document 4: Japanese Patent Application Laid-Open No. 2004-161886

### SUMMARY OF THE INVENTION

### PROBLEMS TO BE SOLVED BY THE INVENTION

In order to solve the above-mentioned problems, an object of the present invention is to provide a new method by which the generation of voids in a liquid encapsulating resin is prevented, and a solvent borne semiconductor-encapsulating epoxy resin composition for use in the method.

### MEANS FOR SOLVING THE PROBLEMS

The present invention is a method for manufacturing a semiconductor package comprising: step (1) of applying a solvent borne semiconductor-encapsulating epoxy resin composition to a first member selected from the group consisting of a semiconductor chip and a circuit board (hereinafter also referred to simply as first member), step (2) of volatilizing a solvent from the above-mentioned applied composition to dry the composition, and step (3) of thermally compression bonding the first member via the applied and dried composition with a second member that is selected from the group consisting of a semiconductor chip and a circuit board and forms a semiconductor chip/circuit board pair or a semiconductor chip/semiconductor chip pair (hereinafter also referred to simply as second member) together with the first member. Hereinafter, the method is also simply called "the manufacturing method of the present invention".

Another embodiment of the present invention is a method for encapsulating a semiconductor comprising: step (1) of applying a solvent borne semiconductor-encapsulating epoxy resin composition to a first member selected from the group consisting of a semiconductor chip and a circuit board, step (2) of volatilizing a solvent from the above-mentioned applied composition to dry the composition, step (3') of thermally compression bonding the first member via the applied and dried composition with a second member that is selected from the group consisting of a semiconductor chip and a circuit board and forms a semiconductor chip/circuit board pair together with the first member. Hereinafter, the method is also simply called "the encapsulation method of the present invention". The present invention is also a solvent borne semiconductor-encapsulating epoxy resin composition comprising an epoxy resin (A), a phenol novolac resin (B) as a curing agent in a proportion such that the number of moles of a phenolic hydroxyl groups to the number of moles of the epoxy groups in the epoxy resin (A) is 0.8 to 1.2 times, a latent curing accelerator (C') and a solvent (D) as essential components. Hereinafter, the composition is also simply called "the composition of the present invention".

### EFFECT OF THE INVENTION

Because of the above-mentioned configurations, the above-mentioned manufacturing method of the present invention and the encapsulation method of the present invention can use, as an encapsulating resin, a solvent borne epoxy resin composition that has been impossible to be used by conventional encapsulation methods, by volatilizing a solvent by drying before encapsulation. Moreover, a step of making a resin composition into a sheet as in a case of using a resin sheet is unnecessary, and in addition, it becomes possible to provide an epoxy resin composition with good curing properties due to no employment of a thermoplastic resin that has been used as a sheeting agent in a large amount and, as a result, has deteriorated the properties of a cured product.

Moreover, thanks to the above-mentioned configurations, the manufacturing method and the encapsulation method of the present invention can increase more the resin viscosity at the time of encapsulation by drying in comparison to a solventless liquid resin sealant, and therefore it can inhibit void development from a substrate. Moreover, the development of a void between wires that has been problematic at the time of pasting a resin sheet is eliminated.

### BRIEF DESCRIPTION OF THE DRAWINGS

[Fig. 1]
   A conceptual scheme of flip chip mounting by the manufacturing method of the present invention and the encapsulation method of the present invention.

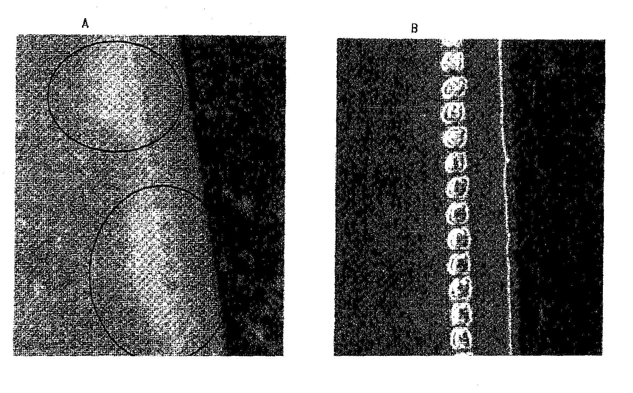

[Fig. 2] A photograph as a substitute for drawing, the photograph microscopically observing a condition of bonding of an encapsulating resin of Example 1 (Fig. B) or Comparative Example 1 (Fig. A) to a semiconductor chip before heat-drying. In the drawing, the sheet resin has been separated from the surface of the chip in the encircled portion of Comparative Example 1 (Fig. A). The present invention is described in detail below.

### MODE FOR CARRYING OUT THE INVENTION

In the manufacturing method and the encapsulation method of the present invention, a solvent borne semiconductor-encapsulating epoxy resin composition containing an epoxy resin (A), a phenol novolac resin (B) as a curing agent in a proportion such that the number of moles of phenolic hydroxyl groups to the number of moles of the epoxy groups in the epoxy resin (A) is 0.8 to 1.2 times, a curing accelerator (C), and a solvent (D) as essential components is used preferably as a solvent borne semiconductor-encapsulating epoxy resin composition.

Epoxy resins that have been used generally as the above-mentioned epoxy resin (A), and examples thereof include a bisphenol A epoxy resin, a bisphenol F epoxy resin, a bisphenol AD epoxy resin, a naphthalene type epoxy resin, a biphenyl type epoxy resin, a glycidylamine type epoxy resin, a alicyclic epoxy resin, a dicyclopentadiene type epoxy resin, a polyether type epoxy resin, and a silicone-modified epoxy resin. These may be used independently singly or alternatively two or more of them may be used in combination. Among these, a naphthalene type epoxy resin, a bisphenol A epoxy resin, a bisphenol F epoxy resin, and a bisphenol AD epoxy resin are preferable, a bisphenol A epoxy resin, a bisphenol F epoxy resin, and a naphthalene type epoxy resin are more preferable, and a naphthalene type epoxy resin is still more preferable from the viewpoint of moisture resistance.

The above-mentioned phenol novolac resin (B) is a product obtained by making a phenol (a compound resulting from replacement of hydrogen of a benzene ring of an aromatic compound by a OH group, such as phenol, cresol, naphthol, alkylphenol, bisphenol, and terpenephenol) undergo condensation polymerization with a formaldehyde using an acid catalyst, and for example, a phenol novolac resin or naphthol novolac resin that is solid at an ordinary temperature (25°C) can be used. The solid phenol novolac resin is not particularly limited and phenol novolac resins which are used ordinarily can be applied, and specific examples thereof include a phenol novolac resin, a cresol novolac resin, an aralkylphenol novolac resin, a biphenylphenol novolac resin, and a terpenephenol novolac resin. Moreover, the solid naphthol novolac resin is also not particularly limited and naphthol novolac resins which are used ordinarily can be applied, and specific examples thereof include an α-naphthol novolac resin and a β-naphthol novolac resin. Among these, a naphthol novolac resin is preferable from the viewpoint of water resistance. These may be used singly or alternatively two or more of them may be used in combination.

The compounding ratio of the above-mentioned epoxy resin (A) and the phenol novolac resin (B) is a proportion such that the number of moles of phenolic hydroxyl groups to the number of moles of the epoxy groups in the (A) is 0.8 to 1.2 times, preferably 0.9 to 1.1 times. Although their compounded amounts vary depending on the equivalent of hydroxyl groups when indicating them by amounts per 100 parts by weight of an epoxy resin, generally, the phenol novolac resin (B) is preferably in an amount of 80 to 120 parts by weight, and the phenol novolac resin (B) is more preferably in an amount of 90 to 110 parts by weight.

Examples of the above-mentioned curing accelerator (C) include imidazole type accelerators, phosphorus-based curing accelerators, phosphonium salt type curing accelerators, bicyclic amidines and their derivatives, organometallic complexes, and urea compounds of polyamines. Moreover, a preferred example of the above-mentioned curing accelerator (C) is a latent curing accelerator (C'). Examples of the latent curing accelerator (C') include an imidazole type accelerator, and a phosphorus-based accelerator. Among such latent accelerators (C'), an encapsulated modified imidazole is preferable.

The incorporated amount of the curing accelerator (C) is preferably 0.2 to 20 parts by weight, and more preferably 2 to 10 parts by weight relative to 100 parts by weight of the epoxy resin (A).

Examples of the above-mentioned solvent (D) include, but are not limited particularly to, ketones, such as acetone, methyl ethyl ketone (MEK), methyl isobutyl ketone (MIBK), and cyclohexanone, and ethers, such as methylcellosolve, ethylene glycol dibutyl ether, and butylcellosolve acetate. Among these, ethers are preferable from the viewpoint of volatility and handleability at the time of thermal curing.

The used amount of the solvent (D) is preferably 10 to 80 parts by weight, and more preferably 20 to 30 parts by weight relative to 100 parts by weight of the resin component. If the used amount is in these ranges, separation of phenols and remaining of a solvent in a resin after polymerization are inhibited.

In the above-mentioned solvent borne semiconductor-encapsulating epoxy resin composition, an inorganic filler can be further incorporated. Examples of the above-mentioned inorganic filler include silica fillers (e.g., fused silica and crystalline silica), particles of metal (e. g. , gold, copper, solder, and silver), quartz glass powder, and inorganic particles, such as calcium carbonate and aluminum hydroxide. Among these, silica fillers are preferable and fused silica is more preferable. The incorporated amount of the inorganic filler is preferably 30 to 80 parts by weight, and more preferably 45 to 65 parts by weight relative to 100 parts by weight of the solid content of the resin composition.

In the use of an inorganic filler, a silane coupling agent can be used. Examples of the above-mentioned silane coupling agent include 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, vinyltrimethoxysilane, and vinyltriethoxysilane. These may be used singly or alternatively two or more of them may be used in combination.

Unless the object of the present invention is disturbed, a defoaming agent, a leveling agent, and a pigment can be used for the composition of the present invention.

The composition of the present invention is usually recommended to be used after compounding respective components in prescribed proportions, agitating them for 60 to 120 minutes, and then conducting degassing under reduced pressure.

In the manufacturing method of the present invention and the encapsulation method of the present invention, in step (1) of applying a solvent borne semiconductor-encapsulating epoxy resin composition to a first member selected from the group consisting of a semiconductor chip and a circuit board, the solvent borne semiconductor-encapsulating resin composition is applied to a joint surface of either the semiconductor chip or the circuit board. To this application can be applied a method by which uniform application can be achieved, such as a printing method, a spin coat method, a roll coater method. The circuit board substrate may be at least one member selected from the group consisting of a resin circuit board substrate, a ceramic circuit board substrate, and a silicon circuit board substrate. Examples of the above-mentioned resin circuit board substrate include, but are not limited particularly to, those usually used as a resin circuit board substrate, such as an epoxy resin circuit board substrate (including a glass epoxy circuit board substrate), a fluororesin circuit board substrate, and a bismaleimide-triazine circuit board substrate, and it may be a flexible resin circuit board substrate (for example, a polyimide resin circuit board substrate). Moreover, the above-mentioned circuit board substrate may be an organic-inorganic hybrid circuit board substrate in which, for example, ceramics or silicon is coated with a resin. The applied amount is adjusted to a minimum amount that is necessary for encapsulation but is not too much. Generally, the application thickness is about 5 to about 50 µm.

Next, step (2) of volatilizing a solvent from the above-mentioned applied composition to dry the composition is a step of drying a solvent borne epoxy resin composition, and substantially no resin curing reaction occurs in this stage. The drying is preferably performed by heat-drying. Although the conditions of the heat-drying depend on the kind of the components of the resin composition and therefore cannot be generalized, the drying temperature is preferably 60 to 180°C and is more preferably 60 to 120°C. The drying time is preferably 30 seconds to 30 minutes. Alternatively, it is also possible to do through-flow drying at room temperature (approximately from 18 to 28°C, preferably 25°C). The resin dried in step (2), for example, in the case of a silicon circuit board substrate, may be subjected to die cutting process. Therefore, a step of die cutting an item prepared by applying and drying a resin composition using a silicon wafer as the first member in step (1) into a chip form may be performed after step (2).

In the manufacturing method of the present invention is next performed step (3) of thermally compression bonding the first member via the applied and dried composition with a second member that is selected from the group consisting of a semiconductor chip and a circuit board and forms a semiconductor chip/circuit board pair or a semiconductor chip/semiconductor chip pair together with the first member. That is, in the manufacturing method of the present invention, the first member and the second member may be a semiconductor chip/circuit board pair or alternatively may be a semiconductor chip/semiconductor chip pair. One example corresponding to the case of the former is a case where a semiconductor chip is mounted to a circuit board by a flip chip bonding method. Examples corresponding to the latter case include cases of applying high-density mounting methods, such as a COC method in which one semiconductor chip having been mounted by wire connection is laminate connected to another semiconductor chip and a TSV method in which a through hole is formed in a semiconductor chip to form an electrode connecting the front surface of the semiconductor chip to the rear surface of the semiconductor chip and then another semiconductor chip is laminate connected onto a semiconductor chip by using that electrode.

In the encapsulation method of the present invention is performed step (3') of thermally compression bonding the first member via the applied and dried composition with the second member that is selected from the group consisting of a semiconductor chip and a circuit board, and forms a semiconductor chip/circuit board pair together with the first member.

By the thermal compression bonding step of step (3) or step (3') usually is formed an electrical connection of semiconductor chips or of a semiconductor chip and a circuit board. In that case, a bump of metal such as gold, copper, and solder that has been formed on the first member or the second member and a corresponding circuit part called a pad that has been formed on the second member or the first member, respectively, are usually connected to each other by such a method as mechanical connection, ultrasonic connection, and gold-tin eutectic connection. Simultaneously, the applied and dried solvent borne semiconductor-encapsulating epoxy resin composition existing between the first member and the second member is heat-cured. The compression bonding temperature is generally 150 to 300°C, preferably 200 to 280°C, and more preferably 220 to 250°C. It is preferable that the compression bonding temperature be higher than the drying temperature. The compression bonding time is generally 0.5 to 10 seconds, preferably 0.5 to 5 seconds. In this case, the resin composition having been dried and solidified in step (2) is melted or softened by heating. The magnitude of the complex elastic modulus E* of the composition at this stage is preferably 500 Pa or more with an upper limit of 1000000 Pa, more preferably 500 to 100000 Pa, and more preferably 500 to 10000 Pa within a temperature range of 25°C to 150°C when being measured using a dynamic viscoelasticity analyzer at a shear rate of 6.28 rad/s (this angular speed is applied also hereafter). When the resin composition of the present invention has a minimum value of its complex elastic modulus of 500 Pa or more as a viscosity when it melts or softens through heating after being dried and solidified, it is possible to inhibit the generation of voids or the engulfment of voids during compression bonding. Although the complex elastic modulus decreases as the temperature of the composition increases through heating, a curing reaction of the composition progresses with the heating, so that the viscosity will increase beyond a certain temperature, that is, generally in the temperature range of from 25°C to 150°C. It is preferable that the minimum value of the magnitude of E* in the above-mentioned temperature range be equal to or more than 500 Pa. In practice, however, the magnitude of the complex elastic modulus at 80°C is preferably equal to or more than 500 Pa and equal to or less than 1000000 Pa, more preferably 500 to 50000 Pa, and still more preferably 500 to 10000 Pa. The measurement of the complex elastic modulus can be performed under conditions including a temperature raising rate of 5°C/min at temperatures of from 25°C to 150°C, a strain amount of 0.1%, and a shear rate of 6.28 rad/s. After step (3), a step of post-curing can be carried out, if needed.

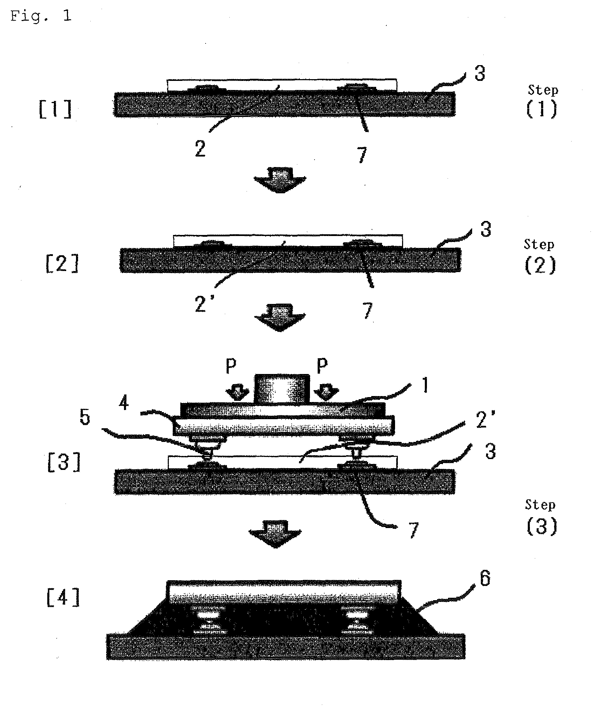

The mounting step in the present invention is explained by taking a case of flip chip mounting as an example. As shown in Fig.1, a composition 2 of the present invention is applied first by a printing method or a spin coat method to a surface, where a semiconductor chip will be arranged, of a substrate 3 with a circuit 7 formed (step (1)) as depicted in [1]. Then, the applied composition is dried by heating into a solid 2' (step (2)) as depicted in [2]. Then, a semiconductor chip 4 is arranged at a prescribed position with a jig 1 as shown in [3], and a bump 5 of metal, such as gold, copper, and solder, is brought into contact with a pad 7 of a substrate, which pad preferably has been provided with tin or solder by plating, and an encapsulating resin 2' is cured under application of heat and pressure (represented by P in the figure), and simultaneously, electrical connection is completed (step (3)). The pressurizing condition is generally 2 to 50 g/bump, and it is preferably 5 to 30 g/bump. Furthermore, post-curing may also be done, if needed. The temperature and time conditions of the post-curing are preferably 120 to 180°C, more preferably 120 to 150°C and preferably 0.5 to 5.0 hours, more preferably 1.0 to 3.0 hours. In this case, as shown in [4], in order to perform sealing well, it is preferable that the level of a fillet do not exceed the upper surface of the semiconductor chip, in addition, it cover the electrode provided around the semiconductor chip. In order to cover the electrode provided around the semiconductor chip uniformly, it is preferable that a fillet 6 be in a uniform shape without irregularities. Although the composition of the present invention was applied onto the substrate in step (1) in Fig. 1, the step is not limited to this and the composition of the present invention may either be applied on the semiconductor chip.

### EXAMPLES

The present invention will be described in more detail below by showing Examples, but the present invention is not limited thereto.

### Examples 1 to 5 and Comparative Examples 1 and 2

Uniform compositions were respectively prepared by compounding the components given in Table 1 (parts by weight) at 25°C. As to the incorporated amounts, the numbers of moles of phenolic hydroxyl groups relative to the numbers of moles of epoxy groups were also shown as respective equivalent ratios. The composition of Comparative Example 1 was dried at 120°C for 3 minutes and was formed into a sheet, so that a sheet-shaped encapsulating resin (30 µm in thickness) was obtained. The composition of Comparative Example 2 was obtained by mixing respective components.

### Measurement of complex elastic modulus E*

The magnitude (Pa) of the complex elastic modulus E* of the composition after drying of each of Examples 1 to 5 and Comparative Example 1 was measured. The composition of Comparative Example 2 was measured in an uncured state. Measurement was performed as follows. That is, the measurement was carried out at a temperature raising rate of 5°C/min at temperatures of from 25°C to 150°C, a strain amount of 0.1%, and a shear rate of 6.28 rad/s by using a dynamic viscoelasticity analyzer. The magnitude of E* at 80°C was shown in Table 1. The fillet of Example 1 uniformly covered the electrode provided around the chip and a fillet in a uniform shape without irregularities had been formed.

The compositions of Examples 1 to 5 were printed onto the below-described circuit board so that the amounts of the compositions of Examples 1 to 5 and Comparative Example 1 become 10 mg, respectively, and then the bonded condition of each encapsulating resin to the substrate was checked by an optical microscope viewed from the above. Then, heat-drying was carried out at 120°C for 3 minutes. The sheet-shaped encapsulating resin of Comparative Examples 1 was arranged on the circuit board, and the condition of bonding was checked by an optical microscope viewed from the above. All of them were evaluated according to the following criteria.

Next, for each sample, after joint-sealing the semiconductor chip and the circuit board, the existence of voids was evaluated by the following method. The results were shown in Table 1. The condition of the joint-sealing is as follows. Furthermore, for each sample, the bond strength was evaluated by the following method. The results were shown in Table 1. In the case of the composition of Comparative Examples 2, 10 mg of the resin composition was put on a substrate and then was cured (curing conditions: 240°C, 5 seconds), so that they were joined, and then the existence of voids was evaluated. In Fig. 2 has shown a photograph as a substitute for drawing of the condition of bonding to a semiconductor chip. The encircled portion in Fig. 2 shows a place in which the encapsulating resin has been separated from the semiconductor chip. Fig. A shows Comparative Example 1 and Fig. B shows Example 1.

Compression bonding conditions: 240°C, 5 seconds, pressurization 10 g/bump.
Post-curing: 150°C, 1 hour.
Circuit board: Epoxy FR substrate of 35 mm × 35 mm × 0.6 mm. The Au pad surface was coated with Pb-free solder.
Chip: 7.3 mm × 7.3 mm × 0.2 mm (544 gold bumps)

### Observation of bonded condition

For samples before drying, the condition of bonding to an encapsulating resin and substrate was observed by the optical microscope viewed from the above. The judgment criteria are as follows.
○: No voids are found in the encapsulating resin, or the sheet-shaped resin has been attached to the chip surface without any space.
△: Voids exist in a part of the encapsulating resin, or a space has been formed partially between the sheet-shaped resin and the chip surface.
×: Voids exist throughout the encapsulating resin, or a space has been formed in a wide range between the sheet-shaped resin and the chip surface.

### Observation of voids

For the samples after jointing, the existence of voids in the encapsulating resin was checked by an IR microscope. Judgment criteria are as follows.
○: No voids are found in the encapsulating resin.
△: Voids exist in a part of the encapsulating resin.
×: Voids exist throughout the encapsulating resin.

### Bond strength (N/mm²)

An adhesive layer having a thickness of 20 µm was formed on a PET film under a curing condition of 120°C/3 minutes, and then the layer was cut in 2 mm × 2 mm together with the PET film. Next, the adhesive layer was removed from the PET film, and this removed layer was then interposed between two silicon chips (one was in a size of 2 mm × 2 mm and the other was in a size of 5 mm × 5 mm), the surfaces of which had been coated with polyimide (PIX 1400, produced by Hitachi Chemical DuPont). Then, they were thermally compression bonded at 240°C/10 N/5 sec, followed by post curing under conditions of 150°C/1h, so that a specimen was prepared. After the specimen was left at rest in a thermostatic, highly-humid bath of 85°C/85%-humidity for 24 hours, the bond strength at 260°C was measured. The bond strength of the composition of Comparative Examples 2 was measured similarly.

The meanings of the terms in tables areas follows.
Epoxy resin (1): 1,6-bis(2,3-epoxypropoxy)naphthalene
Epoxy resin (2): bisphenol A diglycidyl ether
Acid anhydride: triaralkyltetrahydrophthalic anhydride
Novolac resin (1): phenol novolac resin (softening point = 70 to 120°C)
Novolac resin (2): naphthol novolac resin (softening point = 70 to 120°C)
Silica filler (1): average particle diameter = 0.5 µm (spherical fused silica)
Silica filler (2): average particle diameter = 2.0 µm (spherical fused silica)
Silane coupling agent: epoxysilane
Sheeting agent: phenoxy resin
Curing accelerator: imidazole type curing accelerator (encapsulated latent curing accelerator)
Solvent (1): cyclopentanone
Solvent (2): butylcellosolve acetate

**[Table 1]**

| | Example 1 | Example 2 | Example 3 | Example 4 | Example 5 | Comparative Example 1 | Comparative Example 2 |
|---|---|---|---|---|---|---|---|
| Epoxy resin (1) | 12 | 12 | 12 | 12 | 12 | 12 | 12 |
| Epoxy resin (2) | 2 | 2 | 2 | 2 | 2 | 2 | 2 |
| Acid anhydride | - | - | - | - | - | - | 18 |
| Novolac resin (1) (equivalent ratio) | 6 (1.0) | - | - | - | - | 6 (1.0) | |
| Novolac resin (2) (equivalent ratio) | 6 (1.0) | 14 (1.0) | 14 (1.0) | 14 (1.0) | 14 (1.0) | 6 (1.0) | - |
| Sheeting agent | - | - | - | - | - | 3 | - |
| Curing accelerator | 1 | 1 | 1 | 1 | 1 | 1 | 1 |
| Solvent (1) | 25 | - | - | - | - | 25 | - |
| Solvent (2) | - | 25 | 25 | 25 | 25 | - | - |
| Silica filler (1) | 41 | - | - | 44 | 30 | 46 | - |
| Silica filler (2) | - | 44 | 30 | - | - | - | 50 |
| Silane coupling agent | 0.5 | 0.5 | 0.5 | 0.5 | 0.5 | 0.5 | 0.5 |
| Complex elastic modulus E* (after drying) (Pa) (80°C) | 100000 | 3200 | 800 | 7700 | 1800 | 2000000 | 0.2 |
| Bonded condition (before connection) | ○ | ○ | ○ | ○ | ○ | × | - |
| Void (after connection) | ○ | ○ | ○ | ○ | ○ | △ | × |
| Bond strength (N/mm²) | 2.5 | 5.7 | 7.0 | 2.1 | 4.7 | 0.8 | 10.5 |

The above-described Examples 1 to 5 showed that the manufacturing method of the present invention and the encapsulation method of the present invention, both using the composition of the present invention, generated no voids. Moreover, fillets which were in good shape and in a uniform shape without irregularities had been formed. On the other hand, Comparative Example 1 that had been shaped into a sheet form in advance by using a sheeting agent exhibited poor followability to the irregularities of the substrate. Comparative Example 2 used a common solventless type acid anhydride-curable epoxy resin composition.

### EXPLANATION OF SYMBOLS

- 1:: Heat-pressurization jig
- 2:: Solvent borne semiconductor-encapsulating epoxy resin composition
- 2':: Dried resin composition
- 3:: Circuit board
- 4:: Semiconductor chip
- 5:: Gold bump
- 6:: Fillet of a heat-cured encapsulating resin
- 7:: Pad
- P:: Pressurization

## Claims

1. A method for manufacturing a semiconductor package comprising: step (1) of applying a solvent borne semiconductor-encapsulating epoxy resin composition to a first member selected from the group consisting of a semiconductor chip and a circuit board, step (2) of volatilizing a solvent from said applied composition to dry the composition, and step (3) of thermally compression bonding the first member via the applied and dried composition with a second member that is selected from the group consisting of a semiconductor chip and a circuit board and forms a semiconductor chip/circuit board pair or a semiconductor chip/semiconductor chip pair together with the first member.

2. The manufacturing method according to claim 1, wherein the drying is performed by heating at 60 to 180°C in step (2).

3. The manufacturing method according to claim 1 or 2, wherein the drying is performed by heating for 30 seconds to 30 minutes in step (2).

4. The manufacturing method according to any one of claims 1 to 3, wherein the circuit board substrate is at least one member selected from the group consisting of a resin circuit board substrate, a ceramic circuit board substrate, and a silicon circuit board substrate.

5. The manufacturing method according to any one of claims 1 to 4, wherein a metal bump and a pad are connected together in step (3).

6. The manufacturing method according to any one of claims 1 to 5, wherein the magnitude of the complex elastic modulus E* of the composition measured at a shear rate of 6.28 rad/s by using a dynamic viscoelasticity analyzer in a temperature range of from 25°C to 150°C is equal to or more than 500 Pa in step (3).

7. The manufacturing method according to any one of claims 1 to 6, wherein a solvent borne semiconductor-encapsulating epoxy resin composition comprising an epoxy resin (A), a phenol novolac resin (B) as a curing agent in a proportion such that the number of moles of phenolic hydroxyl groups to the number of moles of the epoxy groups in said epoxy resin (A) is 0.8 to 1.2 times, a curing accelerator (C) and a solvent (D) as essential components is used.

8. The manufacturing method according to claims 7, wherein an ether is used as the solvent (D).

9. A method for encapsulating a semiconductor comprising: step (1) of applying a solvent borne semiconductor-encapsulating epoxy resin composition to a first member selected from the group consisting of a semiconductor chip and a circuit board, step (2) of volatilizing a solvent from said applied composition to dry the composition, step (3') of thermally compression bonding the first member via the applied and dried composition with a second member that is selected from the group consisting of a semiconductor chip and a circuit board and forms a semiconductor chip/circuit board pair together with the first member.

10. A solvent borne semiconductor-encapsulating epoxy resin composition comprising an epoxy resin (A), a phenol novolac resin (B) as a curing agent in a proportion such that the number of moles of phenolic hydroxyl groups to the number of moles of the epoxy groups in said epoxy resin (A) is 0.8 to 1.2 times, a latent curing accelerator (C') and a solvent (D) as essential components.

11. The composition according to claim 10, wherein the epoxy resin (A) is at least one member selected from the group consisting of a naphthalene type epoxy resin, a bisphenol A epoxy resin, and a bisphenol F epoxy resin.

12. The composition according to claim 10 or 11, wherein the phenol novolac resin (B) is at least one member selected from the group consisting of a phenol novolac resin, an aralkylphenol novolac resin, a naphthol novolac resin, and a terpenephenol novolac resin.

13. The composition according to any one of claims 10 to 12, further comprising an inorganic filler in an amount of 30 to 80 parts by weight relative to 100 parts by weight of the solid content of the resin composition.

14. The composition according to any one of claims 10 to 13, wherein an ether is used as the solvent (D).
